(19) Europäisches Patentamt
European Patent Office
Office européen des brevets

(11) **EP 2 171 375 B1**

(12) **EUROPEAN PATENT SPECIFICATION**

(45) Date of publication and mention
of the grant of the patent:
**02.09.2020 Bulletin 2020/36**

(21) Application number: **08781500.7**

(22) Date of filing: **08.07.2008**

(51) Int Cl.:
*F25B 49/02* *(2006.01)*   *H05K 7/20* *(2006.01)*

(86) International application number:
**PCT/US2008/069419**

(87) International publication number:
**WO 2009/014893 (29.01.2009 Gazette 2009/05)**

(54) **COOLING CONTROL DEVICE AND METHOD**

KÜHLSTEUERUNGSVORRICHTUNG UND -VERFAHREN

DISPOSITIF ET PROCÉDÉ DE COMMANDE DE REFROIDISSEMENT

(84) Designated Contracting States:
**AT BE BG CH CY CZ DE DK EE ES FI FR GB GR
HR HU IE IS IT LI LT LU LV MC MT NL NO PL PT
RO SE SI SK TR**

(30) Priority: **26.07.2007 US 828701**

(43) Date of publication of application:
**07.04.2010 Bulletin 2010/14**

(73) Proprietor: **Schneider Electric IT Corporation
West Kingston, RI 02892 (US)**

(72) Inventors:
• **BEAN, John, H., Jr.**
**Wentzille, MO 63385 (US)**
• **DONG, Zhihai, Gordon**
**Chesterfield, MO 63017 (US)**

(74) Representative: **Murgitroyd & Company
Murgitroyd House
165-169 Scotland Street
Glasgow G5 8PL (GB)**

(56) References cited:
WO-A-2006/034718     FR-A- 2 864 854
JP-A- 7 269 926         US-A- 5 735 134
US-A1- 2004 083 012

**Description**

BACKGROUND OF INVENTION

1. Field of Invention

Embodiments relate generally to controlling cooling equipment. Specifically, embodiments relate to calculating estimated cooling outputs of cooling equipment in order to control the cooling equipment.

2. Discussion of Related Art

Heat produced by electronic equipment can have adverse effects on the performance, reliability and useful life of the equipment. Over the years, as electronic equipment becomes faster, smaller, and more power consuming, such equipment also produces more heat, making management of heat more critical to reliable short and long term operation.

A typical environment where heat management may be critical includes a data center containing racks of electronic equipment, such as servers and CPUs. As demand for processing power has increased, data centers have increased in size so that a typical data center may now contain hundreds of such racks. Furthermore, as the size of electronic equipment has decreased, the amount of electronic equipment in each rack and power consumption of the equipment has increased. An exemplary industry standard rack is approximately six to six-and-a-half feet (1.83 to 1.98 m) high, by about twenty-four inches (0.61 m) wide, and about forty inches (1.02 m) deep. Such a rack is commonly referred to as a "nineteen inch" rack, as defined by the Electronics Industries Association's EIA-310-D standard.

To address the heat generated by electronic equipment, such as the rack-mounted electronic equipment of a modern data center, air cooling devices have been used to provide a flow of cool air to the electronic equipment. In the data center environment, such cooling devices are typically referred to as computer room air conditioner ("CRAC") units. These CRAC units intake warm air from the data center and output cooler air into the data center. The temperature of air taken in and output by such CRAC units may vary depending on the cooling needs and arrangement of a data center. In general, such CRAC units intake room temperature air at about 22°C (72°F) and discharge cooler air at about 16°C (60°F).

The electronic equipment in a typical rack is cooled as the cool air is drawn into the rack and over the equipment. The air is heated by this process and exhausted out of the rack. Data centers may be arranged in various configurations depending on the purposes of the data center. Some configurations include a room-oriented configuration in which cool air is output in general to the data center room. Other configurations include a row-oriented configuration in which CRAC units and equipment racks are arranged to produce hot and cold air aisles. Still other configurations include a rack-oriented configuration in which each rack has a dedicated CRAC unit.

JP H 07,269,926 presents a control device for air conditioners.

WO 2006/034718 presents a refrigeration system with a compressing unit, and a method of controlling a refrigeration system.

SUMMARY OF INVENTION

The present application discloses a method of controlling a cooling device according to the appended claims. The method comprises receiving an indication of a desired cooling capacity, providing a plurality of possible sets of operating parameters, determining a plurality of sets of estimated cooling outputs, each set of estimated cooling outputs corresponding to a respective one set of the plurality of possible sets of operating parameters, and selecting one set of operating parameters from the plurality of possible sets of operating parameters, the one set of operating parameters corresponding to a set of estimated cooling outputs of the plurality of sets of estimated cooling outputs that matches the desired cooling capacity. Determining the plurality of sets of estimated cooling outputs includes calculating the plurality of sets of estimated cooling outputs. calculating the plurality of sets of estimated cooling outputs includes performing at least one $\varepsilon$-*NTU* calculation for each set of estimated cooling outputs, performing at least one pressure calculation for each set of estimated cooling outputs, and performing at least one enthalpy calculation for each set of estimated cooling outputs

In some embodiments, the method comprises controlling the cooling device to operate using the selected one set of operating parameters. In some embodiments, controlling the cooling device includes adjusting an evaporation temperature of a refrigerant in the cooling device. In some embodiments, adjusting the evaporation temperature includes adjusting a pressure of the refrigerant in the cooling device. In some embodiments, the indication of the desired cooling capacity includes an indication of at least one measured condition.

In some embodiments, each set of operating parameters of the plurality of possible sets of operating parameters includes a different respective refrigerant evaporating temperature..

In some embodiments, calculating the plurality of sets of estimated cooling outputs further includes determining a respective set of estimated cooling outputs of the plurality of sets of estimated cooling outputs for each of the plurality of possible sets of operating parameters based at least in part on the at least one respective $\varepsilon$-*NTU* calculation, the at least one respective pressure calculation, and the at least one respective enthalpy calculation. In some embodiments, the at least one $\varepsilon$-*NTU* calculation includes determining at least one efficiency of an evaporator of the cooling device using a respective set of operating parameters of the plurality of possible sets of operating parameters. In some embodiments, the at least one pressure calculation includes determining at least one pressure of a refrigerant used by an evaporator of the cooling device using a respective set of operating parameters of the plurality of possible sets of operating parameters.

In some embodiments, the at least one enthalpy calculation includes determining at least one enthalpy value of a refrigerant used by an evaporator of the cooling device using a respective set of operating parameters of the plurality of possible sets of operating parameters. In some embodiments, the at least one enthalpy calculation includes determining at least one enthalpy value based, at least in part, on the at least one pressure calculation and the at least one $\varepsilon$-*NTU* calculation. In some embodiments, calculating the plurality of sets of estimated cooling outputs further includes limiting at least part of at least one enthalpy value resulting from the at least one enthalpy calculation to within a bounding range.

In some embodiments, each set of the plurality of sets of estimated cooling outputs includes a respective estimated output cooling capacity. In some embodiments, the estimated set of cooling outputs matches the desired cooling capacity when the estimated set of cooling outputs includes the respective estimated output cooling capacity that has a similar value as the desired cooling capacity. Some embodiments further comprise receiving a subsequent indication of at least one operating condition, and adjusting a current set of operating parameters based, at least in part, on the at least one operating condition. In some embodiments, the at least one operating condition includes at least one of an air temperature, a refrigerant temperature, and a mass airflow. In some embodiments, adjusting the current set of operating parameters includes calculating a second plurality of sets of second estimated cooling outputs based at least in part on the at least one operating condition.

Some embodiments includes an apparatus comprising at least one machine readable medium, the at least one machine readable medium having stored thereon a plurality of machine instructions, the plurality of machine instructions together being able to control at least one computer system to perform a method as described above.

The present application further discloses a cooling device according to the appended claims. The cooling device comprises an evaporator configured to cool air using a refrigerant, a refrigerant supply element configured to supply the refrigerant, at least one sensor configured to measure at least one characteristic, and at least one controller configured to determine a plurality of sets of estimated cooling outputs based, at least in part on the at least one measured characteristic, each set of the plurality of sets of estimated cooling outputs corresponding to a respective one set of a plurality of possible sets of operating parameters, configured to select one set of operating parameters from the plurality of possible sets of operating parameters, the one set of operating parameters corresponding to an estimated set of cooling outputs that matches a desired cooling capacity, and configured to control the cooling device to operate using the selected one set of operating parametersThe controller is configured to perform at least one $\varepsilon$-*NTU* calculation for each set of the plurality of estimated cooling outputs, perform at least one pressure calculation for each set of the plurality of estimated cooling outputs, and perform at least one enthalpy calculation for each set of the plurality of estimated cooling outputs.

Some embodiments further comprise an air moving element configured to provide the air. In some embodiments, controlling the cooling device includes adjusting at least one of a parameter of the refrigerant supply element, and a parameter of the evaporator. In some embodiments, the at least one measured characteristic includes at least one of a refrigerant supply temperature, a mass airflow, and an air return temperature. In some embodiments, the controller is further configured to determine the desired cooling capacity based, at least in part, the at least one measured characteristic. In some embodiments, each set of operating parameters of the plurality of possible sets of operating parameters includes a different respective refrigerant evaporating temperature.

In some embodiments, the controller is configured to determine a respective set of estimated cooling outputs of the plurality of sets of estimated cooling outputs based at least in part on the at least one respective $\varepsilon$-*NTU* calculation, the at least one respective pressure calculation, and the at least one respective enthalpy calculation. In some embodiments, the at least one $\varepsilon$-*NTU* calculation includes determining at least one efficiency of an evaporator of the cooling device operating using a respective set of operating parameters of the plurality of possible sets of operating parameters. In some embodiments, the at least one pressure calculation includes determining at least one refrigerant pressure of the refrigerant flow using a respective set of operating parameters of the plurality of possible sets of operating parameters.

In some embodiments, the at least one enthalpy calculation includes determining at least one enthalpy value of the refrigerant flow using a respective set of operating parameters of the plurality of possible sets of operating parameters. In some embodiments, the controller is configured to perform the at least one enthalpy calculation based, at least in part, on the at least one pressure calculation and the at least one $\varepsilon$-*NTU* calculation. In some embodiments, the controller is configured to limit at least part of at least one enthalpy value resulting from the at least one enthalpy calculation to within a bounding range. In some embodiments, each set of the plurality of sets of estimated cooling outputs includes a respective estimated output cooling capacity. In some embodiments, the estimated set of cooling outputs matches the desired cooling capacity when the estimated set of cooling outputs includes the respective estimated output cooling capacity that has a similar value as the desired cooling capacity.

In some embodiments, the controller is further configured to receive an indication of at least one subsequent operating condition, and to adjusting a current set of operating parameters based, at least in part, on the at least one subsequent operating condition. In some embodiments, the controller is configured to calculate a second plurality of sets of second estimated cooling outputs based at least in part on the at least one subsequent operating parameter. In some embodiments, determining the plurality of sets of estimated cooling outputs includes calculating the plurality of sets of estimated cooping outputs.

One aspect includes a cooling device comprising an evaporator configured to cool air using a refrigerant, a refrigerant supply configured to supply the refrigerant, at least one sensor configured to measure at least one environmental characteristic, and means for determining a plurality of sets of estimated cooling outputs based, at least in part on the at least one measured characteristic, each set of estimated cooling outputs corresponding to a respective one set of a plurality of possible sets of operating parameters, selecting one set of operating parameters from the plurality of possible sets of operating parameters, the one set of operating parameters corresponding to an estimated set of cooling outputs that matches a desired cooling capacity, and controlling the cooling device to operate using the selected one set of operating parameters.

In some embodiments, each set of operating parameters of the plurality of possible sets of operating parameters includes a different respective refrigerant evaporating temperature. In some embodiments, the means is configured to perform at least one $\varepsilon$-NTU calculation for each set of the plurality of estimated cooling outputs, perform at least one pressure calculation for each set of the plurality of estimated cooling outputs, and perform at least one enthalpy calculation for each set of the plurality of estimated cooling outputs. In some embodiments, the means is configured to determine a respective set of estimated cooling outputs of the plurality of sets of estimated cooling outputs based at least in part on the at least one respective $\varepsilon$-NTU calculation, the at least one respective pressure calculation, and the at least one respective enthalpy calculation. In some embodiments, the means is configured to receive an indication of at least one subsequent operating condition, and to adjusting a current set of operating parameters based, at least in part, on the at least one subsequent operating condition.

Embodiments will be more fully understood after a review of the following figures, detailed description and claims.

## BRIEF DESCRIPTION OF DRAWINGS

The accompanying drawings are not intended to be drawn to scale. In the drawings, each identical or nearly identical component that is illustrated in various figures is represented by a like numeral. For purposes of clarity, not every component may be labeled in every drawing. In the drawings:

Figure 1 is a perspective view of a cooling unit of some embodiments;
Figure 2 illustrates a portion of an evaporator according to some embodiments;
Figure 3 illustrates a diagram of components of a cooling device according to some embodiments;
Figure 4 illustrates an example process that may be performed in some embodiments to determine operating parameters and control a cooling device;
Figure 5 illustrates an example process that may be performed for each set of operating parameters of the plurality of sets of operating parameters to determine estimated cooling outputs for that set of operating parameters; and
Figure 6 illustrates a graph of example heat transfer during evaporator operation according to some embodiments.

## DETAILED DESCRIPTION

Embodiments are not limited in their application to the details of construction and the arrangement of components set forth in the following description or illustrated in the drawings. Embodiments are capable of being practiced or of being carried out in various ways. Also, the phraseology and terminology used herein is for the purpose of description and should not be regarded as limiting. The use of "including," "comprising," "having," "containing," "involving," and variations thereof herein, is meant to encompass the items listed thereafter and equivalents thereof as well as additional items.

In one aspect, it is recognized that a set of desired operating parameters may be determined for a cooling device by employing concepts of thermodynamics and heat transfer. In some embodiments, by so determining the set of desired operating parameters, a cooling device may be quickly adjusted to address changes in cooling demand and/or other operating needs. In some embodiments, to determine a set of desired operating parameters, expected cooling outputs at a plurality of possible sets of operating parameters may be calculated. A set of operating parameters that is determined to produce an expected cooling output that match desired cooling outputs may be selected. A cooling device may then be controlled to operate using the set of selected operating parameters.

In some embodiments, the cooling device may be used to cool one or more objects by operating at the selected set of operating parameters. The objects may include electronic equipment, such as computer equipment in one or more standard electronic equipment racks.

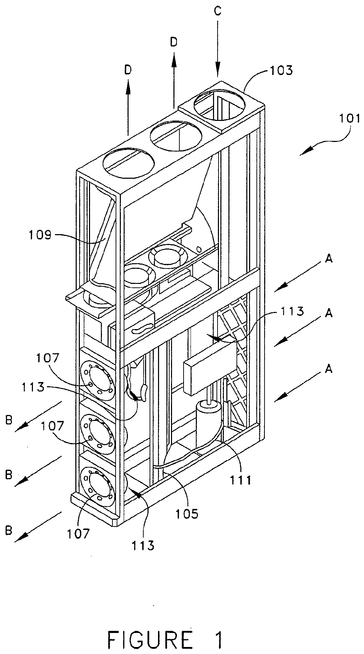

In some embodiments, the cooling device may include a CRAC unit. Examples of CRAC units are disclosed in detail in U.S. Patent Application Nos. 11/335,874 filed January 19, 2006 and entitled "COOLING SYSTEM AND METHOD," 11/335,856 filed January 19, 2006 and entitled "COOLING SYSTEM AND METHOD," 11/335,901 filed January 19, 2006 and entitled "COOLING SYSTEM AND METHOD," 11/504,382 filed August 15, 2006 entitled "METHOD AND APPARATUS FOR COOLING," and 11/504,370 filed August 15, 2006 and entitled "METHOD AND APPARATUS FOR COOLING" which are owned by the assignee of this disclosure. One embodiment of a CRAC unit 101 is illustrated in Figure 1. As shown, the CRAC unit 101 may include a rack 103 configured to house the components of the CRAC unit 101 in the manner described below.

In some implementations, the CRAC unit 101 may include an InfraStruXure cooling unit available from American Power Conversion, Corp., West Kingston, RI and/or any other heating or precision cooling equipment.

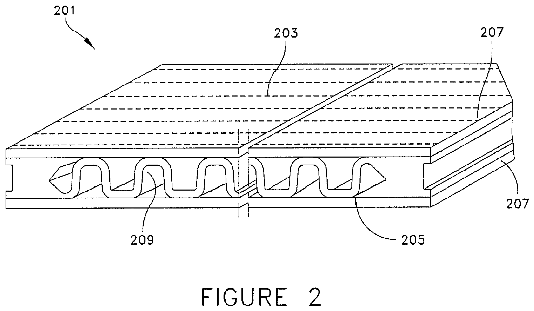

In one embodiment, the CRAC unit 101 may include an evaporator 105 configured to cool an air flow. Figure 2 illustrates a portion of the evaporator 105 in more detail. The portion illustrated in Figure 2 may be referred to as an evaporator coil or slab 201. The evaporator 105 may include any number of such slabs 201 arranged in any manner (e.g., stacked on top of each other). As illustrated, the slab 201 may include a top plate 203, and a bottom plate 205. Refrigerant may flow through the top and bottom plate within microchannels 207 traversing each plate. In one implementation, the plates 203, 205 may be made from any metal such as aluminum and the microchannels 207 may include openings through the metal from one end to another end in any desired pattern. The microchannels 207 may be in any configuration, for example, in one implementation, the microchannels 207 may be arranged to direct refrigerant horizontally from left to right of the evaporator shown in Figure 2. Input and exhaust elements (not shown) may be disposed on the respective sides to supply the refrigerant to the microchannels 207 and return the refrigerant to the rest of the CRAC unit 101. In the discussion herein, the refrigerant, R134a or tetrafluoroethane is used, but it should be understood that any refrigerant may be used in other embodiments. R134a may be used because it offers a low toxicity, zero ozone depletions factor, low global warming potential compared to other common HFCs, low operating pressures, low conductivity, and reasonably high latent heat of vaporization.

The slab 201 may also include a plurality of fins 209 around which air may flow. Air may be drawn through the gaps between the fins 209. The fins 209 may increase heat transfer between the air and the refrigerant by increasing a thermal exchange surface area. As air is drawn over or through the evaporator fins 209, the air may be cooled by the refrigerant (e.g., by heat transfer through the fins 209 and plates 203, 205 into the refrigerant in the microchannels 207). The refrigerant, conversely, may be warmed by the air thereby causing the refrigerant to evaporate in the microchannels 207. It should be recognized that the slab 201 is given as an example only and that any arrangement or type of slab or evaporator may be used in various embodiments.

In some embodiments, the air may be drawn across the evaporator 105 by one or more fans, each indicated at 107 of Figure 1. The fans 107 may be arranged to pull warm air into the CRAC unit 101 from a direction indicated by arrows A, move the air over the evaporator 105 so that the air is cooled, and then exhaust the cooled air from the CRAC unit 101 in a direction indicated by arrows B. As illustrated in Figure 1, a plurality of fans 107, e.g., three, may be used to draw the air through CRAC unit 101.

Fans 107 may be configured to adjust or otherwise vary their speed to increase or decrease the volume of air drawn through the CRAC unit 101 over the evaporator 105. As the fan speed increases, a larger air mass flow may be drawn through the CRAC unit 101. Conversely, as the fan speed decreases, a smaller air mass flow may be drawn through the CRAC unit 101. The fan speed may be controllable by a controller coupled to the CRAC unit 101.

In one embodiment, the CRAC unit 101 may further include a condenser 109 configured to cool the refrigerant as cool air is drawn across the condenser 109. The condenser 109 may include multiple condenser coils to provide a large operational surface area for the condenser 109. The refrigerant may flow within the condenser 109 (e.g., within the condenser coils) in a gaseous form. As air is drawn over the condenser 109 (e.g., over or through condenser coils) the refrigerant may be cooled by the air thereby causing the refrigerant to condense. The air drawn over the condenser may be warmed by the refrigerant and exhausted from the CRAC unit 101. In one embodiment, air may be drawn into the CRAC unit 101 through a plenum along arrow C so as to move the air over the condenser 109 and out of the unit along an air path defined by arrows D. Fans may be provided to achieve the air flow over the condenser 109 as described above. In some other embodiments, the condenser 109 may be disposed separately from a CRAC unit, for example, outside of a room being cooled.

In one embodiment, the flow of the refrigerant through and between the evaporator 105 and the condenser 109 may be facilitated by a compressor 111. The compressor 111 may pump refrigerant through pipes coupling the compressor 111 to the evaporator 105 and the condenser 109 so that the refrigerant is warmed in the evaporator 105 as it cools air and is cooled in the condenser 109 as it warms air.

In some embodiments, if more refrigerant is pumped to the evaporator 105, the evaporator 105 may remove a greater amount of heat from the air flowing over it. If less refrigerant is pumped to the evaporator 105, the evaporator 105 may remove a smaller amount of heat from the air flowing over it.

In some implementations, a compressor (e.g., 111) may be fully variable between a minimum and maximum refrigerant flow rate. Control of the flow rate may be facilitated in any manner. In one embodiment, the compressor (e.g., 111) may be operated at a faster or slower rate to increase or decrease the flow rate, respectively. In other embodiments, one or more valves may be placed within tubes connecting the compressor to other components of the cooling device. The valves may be opened to a level that provides a desired rate of refrigerant flow and/or pressure. For example, one valve may include an evaporator supply valve that controls an input rate of refrigerant, and one valve may include an evaporator pressure regulator valve that controls pressure of evaporating refrigerant within the evaporator. It should be appreciated that embodiments are not limited to any specific compressor configuration.

In one embodiment, the CRAC unit 101 may include or be coupled to one or more sensors 113 to measure one or more physical characteristics of the air flow through the CRAC unit 101 and/or the refrigerant flowing through the CRAC unit. The sensors 113 may include relative humidity sensors, temperature sensors (e.g., wet bulb and/or dry bulb temperature sensors), pressure sensors, absolute humidity sensors, and/or any other desired sensors. The sensors 113 may be disposed in the airflow through the CRAC unit 101, as illustrated in Figure 1, in a data center room in general, within an evaporator, condenser, of refrigerant supply pipe, and/or in an electronic equipment rack. The purpose of the sensors 113 will become apparent as the description of embodiments proceeds.

As discussed above, CRAC units, such as the CRAC unit 101 shown in Figure 1, are typically disposed in a data center room. CRAC units may be disposed near the edge of a data center room and provide general cooling to the entire room, which is filled with rows of equipment racks, in some arrangements. CRAC units may be arranged in rack-based configurations in which a CRAC unit is coupled to an equipment rack to provide dedicated cooling to that specific equipment rack. CRAC units may be arranged in row-based configurations in which equipment racks form hot aisles and cold aisles. CRAC units which are interspersed within the equipment racks intake hot air exhausted by the equipment racks from the hot aisles and output cold air to the cold aisles to cool the equipment racks. In such a configuration, equipment racks and CRAC units may be arranged in any ratio (e.g., two equipment units for every one CRAC unit, etc). CRAC units may be disposed in racks or may be disposed elsewhere, for example, along a floor or ceiling.

It should be appreciated that the above descriptions of the CRAC unit 101 and CRAC unit arrangements are given as examples only. Embodiments are not limited to any particular arrangement of CRAC units or any particular CRAC unit. Furthermore, embodiments are not limited to CRAC units but, rather, may include any cooling device configured to cool any object.

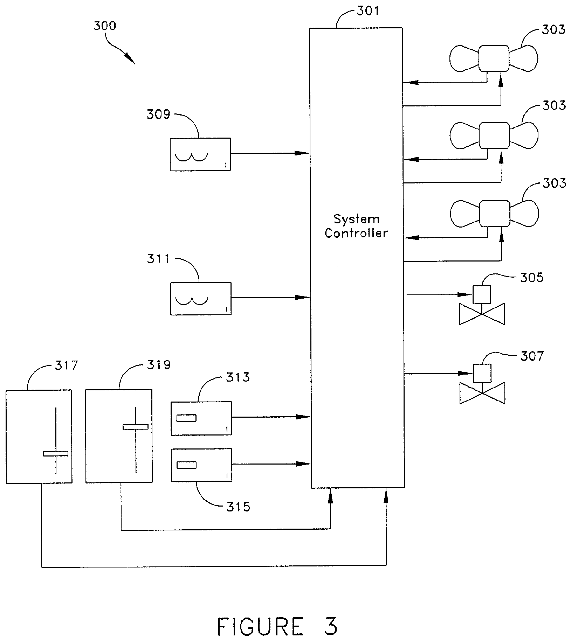

Figure 3 illustrates a diagram of some components of a cooling device 300 (that may be CRAC unit 101 or some other cooling device) used in some embodiments. As illustrated in Figure 3, the cooling device 300 may include a controller 301, one or more controlled devices 303, 305, 307, one or more sensors 309, 311, 313, 315 and one or more input devices 317, 319. The controlled devices 303, 305, 307, sensors 309, 311, 313, 315, input devices 317, 319, and controller 301 may be coupled by a communication network. The communication network may include an internal cooling device bus, a local area network, and/or a wide area network. The network may include a wired portion (e.g., a portion including a mechanical connection between two points) and/or a wireless portion (e.g., a portion without a mechanical connection between two points, such as a Wi-Fi network). It should be understood that embodiments are not limited to the illustrated components of Figure 3 and that other arrangements of a cooling device may be used in various embodiments.

In some embodiments, the controller 301 may be dedicated to a single cooling device (e.g., CRAC unit 101). In another embodiment, the controller 301 may control a plurality of cooling devices, and in some implementations the controller 301 may be part of a main data center control system rather than part of the cooling device. In one embodiment, the controller 301 may include a Philips XAG49 microprocessor, available commercially from the Phillips Electronics Corporation North America, New York, NY. The controller 301 may include a volatile memory, a static memory, or some other machine readable medium that may store information such as executable programs (e.g., machine instructions) and other data useable by the controller 301. The controller 301 may be coupled to an external memory device, such as a hard disk drive (not shown) that may also store executable programs and other data usable by the controller 301.

In some embodiments, the controlled devices 303, 305, 307 may include fans 303, and evaporator/compressor control elements such as valves 305 and 307. In one implementation, valve 305 may include a supply valve that may control a rate of supply refrigerant flow. In one implementation, valve 307 may include an expansion valve that may control a pressure of refrigerant in the evaporator (e.g., by allowing a potion of gaseous refrigerant to exit an evaporator). The controller 301 may communicate with the controlled devices 303, 305, 307 to adjust a parameter of the controlled devices 303, 305, 307, such as fan speed, rate of refrigerant flow, position of expansion valve, etc.

In one embodiment, the controller 301 may perform one or more processes to determine how to control the controlled devices 303, 305, 307. The processes may include executing one or more machine instructions written in a firmware or other memory of the controller 301 to determine when to transmit control signals and which control signals should be transmitted to which controlled devices. The control signals may be transmitted to adjust one or more operating parameters (e.g., fan speed, compressor speed, valve position, etc.) so that a cooling device operates according to a set of desired operating parameters.

To facilitate proper control of operating parameters, in one embodiment, the controller 301 may be coupled to one or more sensors 309, 311, 313, and 315. The sensors 309, 311, 313, and 315 may measure physical characteristics or other information relevant to determining which control signals to send to controlled devices (e.g., 305, 307) and transmit a representation of the measured characteristics to the controller 301 through the communication network. The sensors 309, 311, 313, and 315 may include temperature sensors 309, relative humidity sensors 311, pressure sensors 313, and any other sensors 315 that may measure any physical characteristic relevant to the control of a cooling device. The temperature sensors 309 may include dry bulb air temperature, wet bulb air temperature sensors, and/or refrigerant temperature sensors. The sensors 309, 311, 313, and 315 may be disposed within a CRAC unit (e.g., 101) or other cooling device, generally in a data room, in cooled equipment racks, or any other desired location.

In some embodiments, input devices 317, 319 may include, for example, one or more control panels. The input devices 317, 319 may indicate desired operational conditions, such as fan speed, air temperature, and/or any other desired operational condition to the controller 301. In one implementation, the input device 317 may include a fan controller through which a user (e.g., a data room administrator) may enter a desired fan setting. Fan speed may be controlled to match the input setting thereby determining a mass flow rate of air. Mass flow rate may be determined by reference to a lookup table or other stored value based on the input fan speed. In one implementation, the input device 319 may include a temperature controller through which a user (e.g., a data room administrator) may enter a desired output air temperature. Such a desired output air temperature may be used, as described below, to determine operating parameters of a cooling device.

In one aspect, it is recognized that operating parameters for the cooling device 300 may be calculated by the controller 301 based on one or more measured input characteristics so that the cooling device 300 produces desired cooling outputs. In some embodiments, the operating parameters may be calculated based, at least in part, on thermodynamic and heat transfer theories.

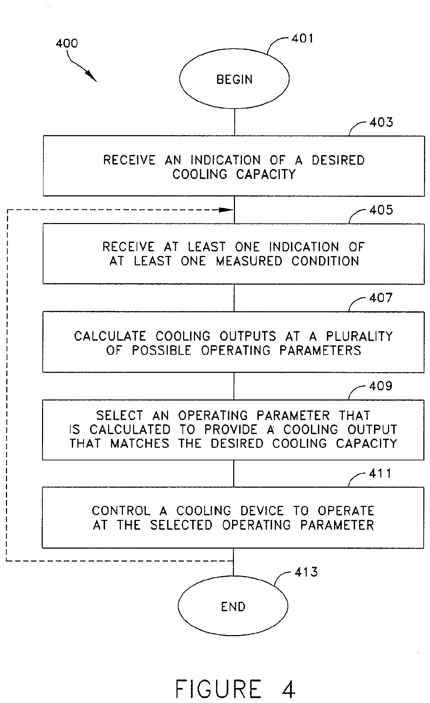

An example process 400 that may be performed (e.g., by controller 301) in some embodiments to determine such operating parameters and control a cooling device is illustrated in Figure 4. Process 400 may begin at block 401.

As indicated at block 403, process 400 may include receiving an indication of a desired cooling capacity. The indication may be received, for example, from a separate process being performed by a controller performing process 400 (e.g., controller 301), another controller performing one or more other processes, an administrator of a data room, another input source coupled to a controller, one or more sensor, and/or any other source. The desired cooling capacity may include a level of cooling that is desired to be output from a cooling device to cool an object. For example, the desired cooling capacity may be the amount of heat to be transferred from air passing over an evaporator of the cooling device so that a piece of cooled electronic equipment is maintained within a safe operating temperature range.

It should be understood that an indication of a desired cooling capacity may include any information from which a desire cooling capacity may be determined. For example, the indication may include an indication of one or more measured characteristics (e.g., characteristics measured by one or more of the sensors). In one embodiment, the desired cooling capacity may be determined as:

$$(1) \quad CFM*(\text{Temperature Return-Temperature Supply})* \rho_{air} *\text{Air Specific Heat},$$

where *CFM* refers to a mass flow of air through a cooling device (e.g., a volume of air per time flowing through an evaporator), Temperature Return (which may be the same as $T_{air(607)}$ below) refers to a temperature of air entering the cooling device, Temperature Supply (which may be the same as $T_{air(601)}$ below) refers to a temperature of air to be supplied by the cooling device, $\rho_{air}$ refers to the density of air at standard conditions, and Air Specific Heat refers to the specific heat of air at standard conditions. In such an embodiment, air density and air specific heat may be known standard values (e.g., air density may be about 1.138 kg/m$^3$ (0.07106 lb/ft$^{3,}$) and air specific heat may be about 1.023 kJ/kgK (0.2444 Btu/lb-°F)). Temperature Return may be a measured value (e.g., as measured by one or more of the sensors), Temperature Supply may be received from an input device as described above, estimated, or determined in any other way, and *CFM* may be a known value based on an input fan speed or likewise determined in any other way. In some implementations, Temperature Supply may include a target value established by an administrator of a data center to maintain the air temperature of the data center at a level optimized for electronic equipment operating in the data center (e.g., about 21°C (70 °F)).

As indicated at block 405, process 400 may include receiving at least one indication of at least one measured condition. In some implementations, the at least one indication may be receiving from one or more sensors and/or one or more other controllers. In some implementations, the at least one indication may include a plurality of indications and the at least one measured condition may include a plurality of measured conditions. Each indication of such a plurality of indications may indicate a respective one of a plurality of different measured conditions. In such an implementation, each measured condition may be measured by a respective sensor configured to transmit an indication of the respective measured condition. In some implementations, receiving the at least one indication of at least one measured condition may be included as part of receiving an indication of a desired cooling capacity. For example, a measured condition, as described above, may be used to determine a desired cooling capacity (e.g., Temperature Return in the above equation).

In some embodiments, the at least one measured condition may include additional measured conditions not indicative of a desired cooling capacity and/or indicative of other things/useful for other purposes. For example, in some implementations, the at least one measured condition may include a temperature of refrigerant entering an evaporator, a mass flow rate of refrigerant, an evaporating temperature of a cooling device, a temperature of air, a dew point of air entering a cooling device, a humidity of air entering a cooling device, and/or one or more pressure measurements of air and/or refrigerant.

As indicated at block 407, process 400 may include calculating one or more sets (i.e., one or more) of cooling outputs at a plurality of possible sets of operating parameters. A possible operating parameter may include one or more operating parameters (e.g., fan speed, compressor speed, evaporating temperature, pressure of refrigerant, etc.) at which a cooling device may be set to operate. Cooling outputs may include, for example, an estimated output cooling capacity when a cooling device is operated at a respective set of operating parameters of the plurality of possible sets of operating parameters.

In some implementations, each of the plurality of sets of operating parameters may include one or more variable conditions. For example, in one implementation, each set of operating parameters of the plurality of sets of operating parameters may include a different evaporating temperature variable. An evaporating temperature may indicate a temperature at which a refrigerant evaporates within the evaporator. The evaporating temperature may be dependent in part on a type of refrigerant and a pressure of the refrigerant within the evaporator, which may be controllable, for example, by adjusting an evaporator pressure regulating valve as described above. In some implementations, the different values of such a variable may span a range of expected/possible values. For example, in one implementation, a set of operating parameters may include a plurality of operating parameters that include different evaporating temperatures that range the possible or expected possible values, for example 13°C to 17°C (56°F to 62°F). In some implementation, the plurality of possible sets of operating parameters may include an evaporating temperature that represent a plurality of steps between a low and high possible evaporating temperature (e.g., each degree, each tenth of a degree, etc.). It should be understood that in some implementations, multiple variables may differ among each set of operating parameters and that the present embodiment is given as a non-limiting example only.

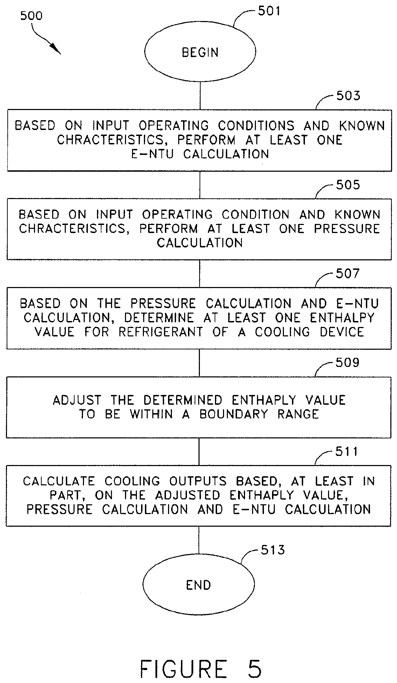

Figure 5 illustrates a process 500 that may be performed for each set of operating parameters of the plurality of sets of operating parameters to determine estimated cooling outputs for that set of operating parameters. Process 500 may be performed, for example, by a same or different controller(s) that performs one or more actions of process 400. Process 500 may be performed once for each set of operating parameters of the plurality of sets of operating parameters. Process 500 may begin at block 501.

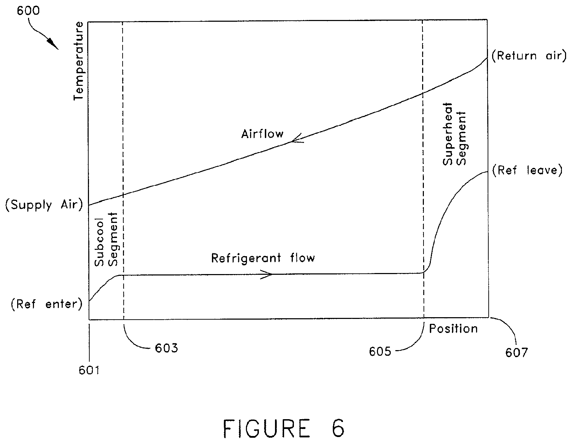

Figure 6 illustrates a graph 600 of example heat transfer during evaporator operation that may be helpful in understanding some embodiments of process 500. The left axis of graph 600 indicates temperature, and the bottom axis indicates position within the evaporator (i.e., distance traveled through the evaporator). Graph 600 illustrates an example state of air flow and refrigerant flow through an example evaporator.

The refrigerant may enter an evaporator at reference point 601 having an initial supply temperature, which may be measured by one or more of the sensors. Between reference point 601 and reference point 603, the refrigerant may be in a subcool state in which all or substantially all of the refrigerant is a liquid. At reference point 603, the refrigerant may reach a temperature at which it begins to evaporate. Between reference points 603 and 605, the refrigerant may evaporate while at a substantially constant temperature (e.g., the evaporating temperature). At reference point 605, all or substantially all of the refrigerant may be evaporated and the refrigerant may again begin to increase in temperature. Between reference point 605 and 607, the refrigerant may be in a superheat state in which all or substantially all of the refrigerant is a gas and the temperature of the gaseous refrigerant increases. At reference point 607, the refrigerant may exit the evaporator for recooling (e.g., at a condenser).

At reference point 607, the air enters the evaporator for cooling and is cooled by the refrigerant through to reference point 601 when it is supplied by the evaporator. The temperature at which the air enters for cooling may be measured by one or more of the sensors in some implementations.

Various characteristics of one or more of the air flow, the refrigerant, heat transfer effectiveness, and other characteristics may vary between respective reference points of the graph 600. In equations below, a variable having a subscript number identifying one or more reference points indicates that the variable refers to a variable at the reference points corresponding to the subscript number. A variable having a subscript range indicating one or more reference points, refers to a variable that is substantially constant between the indicated reference points.

Returning to process 500 of Figure 5, as indicated at block 503, process 500 may include performing at least

one $\varepsilon$-*NTU* calculation based, at least in part, on a set of operating parameters and known characteristics. The $\varepsilon$-*NTU* calculation is a well known thermodynamic calculation of heat transfer effectiveness. In some embodiments, the $\varepsilon$-*NTU* calculation may provide scalar variables $\varepsilon$ (effectiveness) and *NTU* (number of transfer units) that may indicate heat transfer characteristics within a cooling device.

The $\varepsilon$-*NTU* calculation may include determining a Reynolds number for each of air and refrigerant in an evaporator of a cooling device, in accordance with known fluid mechanics theory. The Reynolds number may indicate a ratio of inertial forces to viscous forces in each of the air flow and the refrigerant flow. The Reynolds number may be calculated according to the following equations:

$$(2) \qquad \mathrm{Re}_{air} = \rho_{air} * 60 * \frac{SCFM}{A_{slab}} * \frac{d_{fin}}{12 * \mu_{air}}$$

and

$$(3) \qquad \mathrm{Re}_{ref} = 4 * \frac{\dfrac{m_{ref} * 60}{39 * 11}}{3.14 * \dfrac{d_{tube}}{12} * \mu_{ref}},$$

where $\mathrm{Re}_{air}$ indicates a Reynolds number for air flowing through an evaporator and $\mathrm{Re}_{ref}$ indicates a Reynolds number for refrigerant flowing through the evaporator. $\rho_{air}$ indicates a density of air, which in some implementations may be a constant value of approximately 1.138 kg/m$^3$ (0.07106 lb/ft$^3$) and in other implementations may be a measured value. *SCFM* refers to an air flow rate, which may be determined from one or more of the sensors and an indication of which may be received by a controller (e.g., at block 405). In some implementations, *SCFM* may be adjusted to reflect the air flow relevant to the standard condition set in accordance with known methods. In some implementations, Reynolds numbers for air may from about 280 to about 600, and Reynolds numbers for refrigerant may range from about 260 to about 1300. It should be recognized that these are example ranges only and not meant to be limiting in any way.

$A_{slab}$ refers to the area of an entire evaporator slab, which may be a known characteristic of a cooling device. In one example implementation this may be about 4622.44 cm$^2$ (716.48 inches$^2$). $d_{fin}$ indicates the hydraulic diameter of each fin of an evaporator, which may be a known characteristic of a cooling device, e.g., 0.35 cm (0.126 inches). $\mu_{air}$ indicates a dynamic viscosity of the air flowing over the evaporator, which may be an approximately constant value at operating parameters of a cooling device (e.g., equal to about (0.00019 Pa s (0.04531 lb/(hr-ft)))). $m_{ref}$ may indicate a mass flow rate of refrigerant supplied, which may be determined from the desired cooling capacity value and a known value regarding the provided cooling capacity per mass of provided refrigerant (e.g., 90 Btu/lb for example refrigerant R134a) by, for example, by dividing a desired cooling capacity per time value with a known cooling capacity per mass value. $d_{tube}$ indicates the hydraulic diameter of each microchannel through which refrigerant flows, which may be a known characteristic of a cooling device, e.g., 0,12977 cm (0.05109 inches). And, $\mu_{ref}$ indicates a dynamic viscosity of the refrigerant flowing through the evaporator when in liquid form, which may be an approximately constant value (e.g., 0.00022 Pa s (0.5325 lbs/ft-hr)).

The constants 12 and 60 may be unit conversions from inches and minutes. The constant 39 may be a geometric property of the evaporator referring to the number of slabs. The constant 11 may also be a geometric parameter of the evaporator that refers to the number of openings (e.g., microchannels) in each slab.

Using the calculated Reynolds number, a Nusselt number may be calculated for each of the air and refrigerant. The Nusselt number may adjust theoretical values of thermodynamic equations that account for only conduction into values that take into account convection and conduction. The Nusselt numbers may be proportional to respective Reynolds numbers according to the following equations for an example cooling device:

$$(4) \qquad Nusselt_{air(603,605)} = 0.027 * \mathrm{Re}_{air}^{\,0.9633}$$

$$(5) \qquad Nusselt_{ref(603,605)} = 0.2426 * \mathrm{Re}_{ref}^{\,0.6681}$$

where $Nusselt_{air(603,605)}$ refers to the Nusselt number for air, and $Nusselt_{ref(603,605)}$ refers to the Nusselt number for refrigerant. The exponents and constants may vary from one cooling device to another. These variables may be determined through experimentation for a particular evaporator, by varying operating parameters and measuring temperatures of air and refrigerant throughout the evaporating cycle. A curve may then be fit to recorded data to determine the Nusselt equations, in known fashion. In some implementations, Nusselt numbers for air may range from about 5.5 to about 13, and Nusselt numbers for refrigerant may range from about eight to about 35. It should be recognized that these are example ranges only and not meant to be limiting in any way.

Using the determined Nusselt numbers, film coefficients may be calculated for the evaporator. The film coefficient may be an indication of resistance to heat transfer between the air or refrigerant and the evaporator, respectively. The following equations may be used to determine the respective film coefficients:

$$(6) \qquad HTC_{air(603,605)} = Nusselt_{air(603,605)} * \frac{k_{air}}{\dfrac{d_{fin}}{12}}$$

$$(7) \qquad HTC_{ref(603,605)} = Nusselt_{ref(603,605)} * \frac{k_{ref}}{\dfrac{d_{tube}}{12}}$$

where $HTC_{air}$ refers to the film coefficient of the air with respect to the evaporator and $HTC_{ref}$ refers to the film coefficient of the refrigerant with respect to the evaporator. $k_{air}$ refers to the thermal conductivity of air, a known value that may be approximately constant over typical temperature variations in cooling devices (e.g., 0.0249W/mK (0.144 Btu/Hr-Ft-°F)). $k_{ref}$ refers to the thermal conductivity of the refrigerant, which also may be a value that depends on the state condition of the refrigerant, and for R134a, may range from about 0.1247 W/mK (0.0721 Btu/Hr-Ft-°F) to about 0.0069 W/mK (0.004 Btu/Hr-Ft-°F). In some implementations, film coefficients for air may range from about eight to about 19, and film coefficients for refrigerant may range from about 100 to about 400. It should be recognized that these are example ranges only and not meant to be limiting in any way.

Using the determined film coefficient values, the value of *NTU* (i.e., number of transfer units), which is a measurement of an evaporator's ability to change the temperature of the air and refrigerant passing through the evaporator, may be determined. The following two equations may be solved in tandem in any of a variety of known mathematical methods to determine the value of *NTU* by solving for unknown variables *NTU* and *UA* (i.e., a measure of efficiency):

$$(8) \qquad \frac{1}{UA_{(603,605)}} = \frac{1}{HTC_{air(603,605)} * A_{fin\_total}} + \frac{1}{HTC_{ref(603,605)} * A_{reftotal}}$$

$$(9) \qquad NTU_{(603,605)} = \frac{UA_{(603,605)}}{Cp_{air} * m_{air}}$$

where $A_{fin\_total}$ refers to a total area of evaporator fins over which air flows, which in one implementation may be about 24,54 m² (264.15 ft²). $A_{reftotal}$ refers to the total area through which refrigerant flows. $Cp_{air}$ refers to the isobaric specific heat of air at the dew point temperature of the air supply. The dew point temperature may be determined from a measurement of the dry bulb and wet bulb temperatures (e.g., measured by one or more sensors described above) in accordance with known methods. In one implementation, the dry bulb and wet bulb temperatures may be used as variables of a program designed to determine the dew point temperature of the air from these values. One such program that may be used in some implementations includes the Engineering Equation Solver software from F-Chart Software, Inc. of Madison, WI. The isobaric specific heat at the dew point temperature may be determined by reference to a lookup table indicating the isobaric specific heat at the identified dew point temperature, which may be known values. $m_{air}$ refers to mass flow rate of air, which may be a measured value or determined from a known fan speed as described above. In some implementations, *UA* may range from about 1,600 to about 3,800, and $NTU_{(603,605)}$ may range from about 1.06 to about 1.15. It should be recognized that these are example ranges only and not meant to be limiting in any way.

Using the value of *NTU,* the value of *ε*, or effectiveness, may be solved according to the following equation:.

# EP 2 171 375 B1

$$(10) \quad \varepsilon = 1 - e^{-NTU_{(603,605)}}$$

In some implementations, $\varepsilon$ may range from about 0.65 to about 0.70. It should be recognized that these are example ranges only and not meant to be limiting in any way.

In some implementations, variables related to geometry and other variables may be pre-computed before each $\varepsilon$-NTU computation, measured or determined in any other way rather than stored in a lookup table as described above. In some implementations, variables such as viscosity and density may be variable with temperature and/or pressure change. In some embodiments, for some calculations, values at an expected mean, standard, and/or dew point temperature and/or pressure may be used for such variables, which may be determined for example in advance and stored in a lookup table.

It should be recognized that embodiments are not limited to any particular method of performing an $\varepsilon$-NTU calculation and that the above described embodiments are given as non-limiting examples only.

As indicated at block 505, some embodiments of process 500 may include performing at least one pressure calculation based at least in part on the set of input operating parameters and known or predetermined parameters. In some implementations, pressure calculations may be based on Reynolds numbers and/or characteristics of a particular refrigerant. For example, for R134a, the pressure change from entry to exit in an example evaporator may be determined by the following equation:

$$(11) \quad PD_{hx} = 0.000004 * \mathrm{Re}_{ref}^{2} - 0.0016 * \mathrm{Re}_{ref} - 0.1472$$

Similar to the Nusselt equations above, this pressure equation may be different among different types of evaporators. An equation may be developed for each evaporator type by measuring pressure change across the evaporator before deployment, for example. In some implementations, $PD_{hx}$ may range from about 3.45 bar (50 psig) to about 4.48 bar (65 psig). It should be recognized that these are example ranges only and not meant to be limiting in any way.

A ratio of pressures between reference points 601 and 603 of graph 600 may be given by:

$$(12) \quad Ratio_{subcool} = 0.0049 * (T_{evap} - T_{ref(601)}) - 0.0018$$

where $T_{ref(601)}$ may refer to the supply temperature of the refrigerant measured by one or more sensors, and $T_{evap}$ may refer to an evaporation temperature (i.e., one of the set of operating parameters that may vary among each of the plurality of sets of operating parameters). This pressure equation may also be different among different types of evaporators. An equation may be developed for each evaporator type by measuring pressure change across the evaporator before deployment, for example. In some implementations, $Ratio_{subcool}$ may range from about zero percent to about three percent. It should be recognized that these are example ranges only and not meant to be limiting in any way.

A ratio of pressures at reference points 605 and 607 may be given by:

$$(13) \quad Ratio_{\sup heat} = 0.0026 * (T_{ref(607)} - T_{evap}) + 0.0029$$

where $T_{ref(607)}$ indicates a temperature of the refrigerant returned from the evaporator after used for cooling the airflow. $T_{ref(607)}$ may be an estimated value in some implementations, or determined in any other desired way. For example, in one implementation, $T_{ref(607)}$ may be estimated as two or three degrees Fahrenheit above an evaporating temperature of the refrigerant (i.e., $T_{evap}$), which may be a known value, as described below. The above pressure equation may be different among different types of evaporators. An equation may be developed for each evaporator type by measuring pressure change across the evaporator before deployment, for example. In some implementations, $Ratio_{\sup heat}$ may range from about 1.3% to about 7.5%. It should be recognized that these are example ranges only and not meant to be limiting in any way.

Accordingly, pressure changes at each reference point in the graph 600 may be calculated by solving the following equations:

$$(11) \quad P_{ref(601)} = P_{ref(603)} + Ratio_{subcool} * PD_{hx}$$

$$(12) \quad P_{ref(603)} = 2P_{evap} - P_{ref(605)}$$

$$(13) \, P_{ref(605)} = P_{evap} - \left[1 - Ratio_{subcool} - Ratio_{sup\,heat} - \left(\frac{P_{ref(603)} - P_{evap}}{PD_{hx}}\right)\right] * PD_{hx}$$

$$(14) \quad P_{ref(607)} = P_{ref(601)} - PD_{hx}$$

where $P_{evap}$ refers to the rated evaporating pressure of the refrigerant used (e.g., R134a) at the evaporating temperature (e.g., one of the set of operating parameters), and may be determined from a lookup table of known values, for example.

As indicated at block 507, some embodiments of process 500 may include determining at least one enthalpy value based, at least in part on the at least one pressure calculation and the at least one $\varepsilon$-NTU calculation.

Enthalpy values may be known for a particular refrigerant at a known temperature, pressure and a state characteristic of the refrigerant (i.e., quality). Accordingly, a lookup table may be used to determine enthalpy of the refrigerant at reference points of the graph 600. For example, values for R134a refrigerant at particular pressure, temperature and quality combinations are known and may be obtained by cross referencing an appropriate lookup table with those values. Other methods of determining enthalpy may be used in other embodiments.

In some implementations, four enthalpy values may initially be determined for the refrigerant: $h_{ref(601)}$, $h_{ref(603)}$, $h_{ref(605)}$, and $h_{ref(max)}$. $h_{ref(601)}$ may refer to the enthalpy at reference point 601 when the refrigerant (e.g., R134a) is at a pressure of $P_{ref(601)}$ at a temperature of $T_{ref(601)}$, and about 100% liquid. $h_{ref(603)}$ may correspond to an enthalpy of the refrigerant at reference point 603, when the pressure is at $P_{ref(603)}$, the refrigerant is at its evaporation temperature and the refrigerant is about 100% liquid. $h_{ref(605)}$ may refer to the calculated enthalpy at reference point 605, when the refrigerant is at the evaporating temperature, a pressure of $P_{ref(605)}$, and about 100% gaseous. And, $h_{ref(max)}$ may be a maximum enthalpy when the refrigerant is exiting the evaporator at reference point 607. For determining $H_{ref(max)}$, the input air temperature may be used since this is a known and easily measurable characteristic above which the refrigerant may no longer cool the air. $h_{ref(max)}$ may then be the enthalpy of the refrigerant at the input air temperature and the pressure $P_{ref(607)}$ when about 100% of the refrigerant is gaseous. In some implementations, rather than the input air temperature, a temperature that is a buffer amount below the input temperature may be used (e.g., 0.834 degree Celsius (1.5 degrees Fahrenheit) below input air temperature).

In some implementations, enthalpy values for air may range from about 35 kJ/kg (15 Btu/Lb) to about 60 kJ/kg (26 Btu/lb), and enthalpy values for refrigerant may range from about 60 kJ/kg (26 Btu/lb) to about 279 kJ/kg (120 Btu/lb). It should be recognized that these are example ranges only and not meant to be limiting in any way.

Using the determined enthalpy, and other determined values, temperature of the air at reference points 603 and 605 of graph 600 may be determined by solving the below pair of equations for variables $T_{air(603)}$ and $T_{air(605)}$.

$$(15) \, m_{ref} * 60 * (h_{ref(605)} - h_{ref(603)}) = Cp_{air} * m_{air} * (T_{air(605)} - T_{air(603)})$$

$$(16) \quad \varepsilon = \frac{T_{air(605)} - T_{air(603)}}{T_{air(605)} - T_{ref(603)}}$$

In some implementations, values of $T_{air(603)}$ may range from about 21 °C (70°F) to about 35°C (95°F), and values for $T_{air(605)}$ may range from about 16°C (60°F) to about 24°C (75°F). It should be recognized that these are example ranges only and not meant to be limiting in any way.

Using the calculated temperature values and other solved variables, a value of enthalpy at reference point 607 may be determined by solving for $h_{ref(607)}$ in the following equation:

$$(17) \quad m_{ref} * 60 * (h_{ref(607)cal} - h_{ref(605)cal}) = Cp_{air} * m_{air} * (T_{air(607)} - T_{air(605)})$$

As indicated at block 509, process 500 may include adjusting one or more determined enthalpy values and temperature values. Such an adjustment may, for example, place one or more of the determined enthalpy values and temperature values to within boundary values that help limit the calculations to physically possible or physically expected values. For example, $T_{air(605)}$ may be limited to a value that is no greater than the calculated $T_{air(607)}$ value. Enthalpy at reference point 607 may be set to at least as great a value as enthalpy at reference point 601 and no greater a value than the calculated maximum value. Temperature at reference point 605 may be set to be at lest as great as the temperature at reference point 607. And, enthalpy at reference point 605 may be limited to less than or equal to enthalpy at reference point 607.

As indicated at block 511, process 500 may include calculating one or more cooling outputs, based at least in part on the enthalpy, pressure, and $\varepsilon$-NTU calculations. One cooling output may include an estimated cooling capacity. The estimated cooling capacity output may be calculated according to the following equation:

$$(18) \quad Q = m_{ref} * 60 * (\frac{h_{ref(607)} - h_{ref(601)}}{3412}) ,$$

where Q indicates the estimated output cooling capacity, and 60 and 3412 are unit conversions regarding minutes and Js (BTUs). Another heating output may include output air temperature output ($T_{air(601)}$) calculated by solving the following equation for $T_{air(601)}$:

$$(19) \quad Q = Cp_{air} * m_{air} * (\frac{T_{air(607)} - T_{air(601)}}{3412})$$

In some implementations, a temperature output of the refrigerant may be determined by reference to a lookup table. For example, the temperature corresponding to the refrigerant (e.g., R134a) with an enthalpy equal to the $h_{ref(607)}$ determined value and at a pressure equal to $P_{ref(607)}$ may be determined by reference to a lookup up table storing such known values. Further, some implementations may include determining any other desired cooling outputs such as quality of output refrigerant, which may be determined, for example, by reference to a lookup table.

It should be recognized that process 500 is given as an example only. Other embodiments may include additional and/or alternative actions to determine cooling outputs. Process 500 or an alternative process may be performed for each possible set of operating parameters and output a set of cooling outputs.

Referring again to Figure 4, process 400 may continue at block 409. As indicated at block 409, process 400 may include selecting a set of operating parameters from among the plurality of sets of operating parameters. Selecting the set of operating parameters may include selecting the set of operating parameters that provides calculated cooling outputs that matches the desired cooling capacity and/or any other desired output cooling parameter. For example, some embodiments may select the set of operating parameters determined to provide cooling outputs that include an output cooling capacity closest to the desired cooling capacity. In some implementations, the set of operating parameters that provides a cooling capacity and/or supply air temperature that is also at least as great as the desired cooling capacity may be selected.

As indicated at block 411, process 400 may include controlling one or more cooling devices to operate at the selected operating parameter. Controlling may include transmitting one or more electronic signals from a controller (e.g., 301) to a controlled device (e.g., 303, 305, 307). In some implementations, controlling may include adjusting one or more valves to generate evaporating pressure within an evaporator, and/or adjusting any desired device.

In one implementation, for example, a set of operating parameters may include to one or more parameters such as valve positions and/or adjustments to other controlled devices. Such positions and adjustments may be stored, for example in one or more lookup tables. In other implementations, such positions and/or adjustments may be determined in any other was such as by using one or more equations.

In some embodiments, process 400 may end at block 413. In some embodiments process 400 may loop to block 405, as indicated by a dashed line in Figure 4 and calculate a second set of cooling output values and make an adjustment and/or select a new set of operating parameters. In subsequent iterations through the loop of process 400, measured values may indicate updated measurements (i.e., current operating conditions). By using such updated measurements, the selected operating parameter may change based on changing measured conditions. In some implementations, such changes to measured conditions may reflect a change caused, in part, by changes to the operating parameters from a prior iteration. By performing subsequent passes through the loop, such changes may be accounted for in selecting a new operating parameter and may converge to a stable value.

In some implementations, when a new desired cooling capacity is received, process 400 may begin again at block 401. Such a new desired cooling capacity, for example, may reflect a change in the operation of a piece of electronic equipment being cooled (e.g., a high demand period for a data center), a change by an administrator, or any other change.

It should be recognized that process 400 is given as an example only. Other embodiments may include additional and/or alternative actions in any order.

One specific non-limiting example implementation may include a heat exchanger having geometric parameters (such as those included in the above described equations) of $d_{tube}$ = 0.12977 cm (0.05109 inches), $d_{fin}$=0.32 cm (0.126 inches), $A_{coil}$ = 0.462 m2 (4.976 ft2), $A_{fin\_total}$ = 24.5 m2 (264.1 ft2), and $A_{reftotal}$ = 4.04 m2 (43.52 ft2). Such an example implementation may determine estimated cooling outputs using one or more estimated, known, measured parameters, input, or otherwise determined parameters, as discussed above or otherwise, of

$$k_{ref} = 0.08795 \text{ W/m K} (0.05085 \frac{Btu}{hr \cdot ft \cdot {}^{o} F}), \quad \mu_{ref} = 0.00022 \text{ Pa s} (0.5325 \frac{lb}{hr \cdot ft}),$$

$$k_{air} = 0.2598 \text{ W/m K} (0.01502 \frac{Btu}{hr \cdot ft \cdot {}^{o} F}), \quad \mu_{air} = 0.00019 \text{ Pa s} (0.04531 \frac{lb}{hr \cdot ft}),$$

$$\rho_{air} = 1.138 \text{ kg/m}^3 (0.07106 \frac{lb}{ft^3}), \quad T_{dewair} = 13°C \ (55 \ °F), \quad T_{ref(607)} = 15°C \ (59.28 \ °F), \text{ and}$$

$$Cp_{air} = 1023.25 \text{ J/kg °C} (0.2444 \frac{Btu}{Lb \cdot {}^{o} F})$$

An input may be recivied indicating an *SCFM* = 2720 SCFM, corresponding to an

$$m_{air} = 5518 \text{ kg/h} (12166 \frac{lb}{hr}), \text{ a } T_{air(607)} = 31.6°C \ (88.9 \ °F), \text{ and a desired supply air temperature, estimated}$$

supply air temperature, and/or measured supply air temperature of about 21°C (70 °F). From these values, and the above known values, a desired cooling capacity of 15.68 kW may be determined (e.g., from equation 1).

In some implementations, a first set of possible operating conditions in such a heat exchanger may include $m_{ref}$ = 5.39 kg/min (11.88 lb/min), $T_{evap}$ = 16°C (60 °F), corresponding to a $P_{evap}$ of 3.96 bar (57.46 Psig) when R134a is used as a refrigerant, and $T_{ref(601)}$ = 14°C (58 °F). One or more estimated cooling outputs may be determined for this first set.

In such an example implementation a Reynolds number of air may be determined (e.g., using equation 2 above) equal to 540, and a Reynolds number of refrigerant may be determined (e.g., using equation 3 above) equal to 933.6. Having determined the Reynolds numbers, a Nusselt number of air may be determined (e.g., using equation 4) equal to 11.57, and a Nusselt number of refrigerant may be determined (e.g., using equation 5) equal to 23.4.

Film coefficients may be determined based on the Nusselt numbers and Reynolds numbers. In this example calculation, the film coefficient for air may be determined (e.g., using equation 6) equal to

$$2.37 \text{ W/m K} (16.56 \frac{Btu}{hr \cdot ft^2 \cdot F}), \text{ and the film coefficient for refrigerant may be determined (e.g., using equation}$$

$$7) \text{ equal to } 40.27 \text{ W/m K} (279.4 \frac{Btu}{hr \cdot ft^2 \cdot F}).$$

An $\varepsilon$ -*NTU* calculation may be completed by solving equations 8, 9, and 10 for $\varepsilon$ and *NTU.* In the example calculation, number of heat transfer units (*NTU*) may be determined (e.g., by solving equations 8 and 9 together) to equal 1.082. In some implementations, *UA* (i.e. a measure of overall efficiency) may also be determined when solving equations 8 and 9 (e.g., in the example calculation to be $1698 \text{ W/K} (3218 \frac{Btu}{hr \cdot {}^{o} F})$ ). $\varepsilon$ may then be determined (e.g., using equation 10) to equal 0.6611.

$\varepsilon$ may be used to perform one or more pressure calculations, as described above. In the example calculation, $PD_{hx}$ may be determined (e.g., from equation 11) to equal 0.127 bar (1.846 Psig), $Ratio_{subcool}$ may be determined (e.g., from equation 12) to equal 0.008, and $Ratio_{supheat}$ may be determined (e.g., from equation 13) to equal 0.001032. $P_{ref(601)}$, $P_{ref(603)}$, $P_{ref(605)}$, and $P_{ref(607)}$ may be determined (e.g., by solving equations 11, 12, 13, and 14) to equal 4.03 bar (58.39 Psig), 4.02 bar (58.37 Psig), 3.89 bar (56.54 Psig), and 3.89 bar (56.54) Psig, respectively.

Various enthalpy values may be determined after the pressure values are determined, for example, by referencing one or more lookup tables using the determined/estimated temperature, pressure values, and quality values. In the example calculation in which refrigerant R134a is used, $h_{ref(601)}$ may be determined to be

$$71.62 \text{ kJ/kg} (30.79 \frac{Btu}{lb}), h_{ref(603)} \text{ may be determined to be } 73.64 \text{ kJ/kg} (31.66 \frac{Btu}{lb}), h_{ref(605)} \text{ may be de-}$$

termined to be 259.12 kJ/kg $(111.4 \frac{Btu}{lb})$, and $h_{refmax}$ may be determined to be $259.12$ kJ/kg $(111.4 \frac{Btu}{lb})$.

Knowing the enthalpy values, $T_{air(603)}$ and $T_{air(605)}$ may be determined (e.g., by solving equations 15 and 16) to equal 21°C (69.8 °F) and 31.6 °C 88.9 °F. These temperature values may be used to determine $h_{ref(607)}$ (e.g., by solving equation 17) to equal 259.12 kJ/kg (111.4 $\frac{Btu}{lb}$).

One or more additional cooling outputs may be determined based on the above calculated values. For example in the example calculation, a total output cooling capacity (Q) of 16.83 kW and an output air temperature ($T_{air(607)}$) of 20.89 °C (69.59 °F) may be determined (e.g., by solving equations 18 and 19).

In some implementations, similar calculations may be performed for a plurality of possible sets of operating conditions. For example, a second set of operation conditions may include $m_{ref}$= 5.39 kg/min (11.88 lb/min), $T_{evap}$= 16°C (60 °F), and $T_{ref(601)}$ = 14°C (58 °F). Such a set of operating conditions may result in cooling outputs of Q = 15.27 kW and calculate output air temperature ($T_{air(607)}$) of 21.88 °C (71.38 °F). One or more of these cooling outputs may be compared with the desired cooling capacity output of 15.68 from above and the previously calculated cooling outputs. Based on the comparison, the first set of cooling parameters may be selected since the first set provides an estimated cooling capacity that matches (e.g., is at least as great as) the desired output cooling capacity. A cooling device may then be operated at the first set of possible operating conditions, and further calculation may be performed using later measured, estimated, input, or otherwise determined values (e.g., measured output air temperature and supply air temperature, etc.) so that estimates may more accurately represent actual outputs.

It should be recognized that the example calculation is given as a non-limiting example calculation only.

Although embodiments have been described with respect to cooling electronic equipment in data center environments, it should be recognized that examples are not so limited. Rather, examples may be used to provide cooling in any environment to any object and/or space. For example, examples may be used with telecommunication equipment in outdoor environments or shelters, telecommunication data centers, and/or mobile phone radio base-stations. Examples may be used to with precious goods such as art work, books, historic artifacts and documents, and/or excavated biological matters (for example, for preservation purposes). Examples may be used for preservation of meats, wines, spirits, foods, medicines, biological specimens and samples, and/or other organic substances. Further examples may be used for process optimization in biology, chemistry, greenhouse, and/or other agricultural environments. Still other embodiments may be used to protect against corrosion and/or oxidization of structures (for example, buildings, bridges, or large structures).

**Claims**

1. A method of controlling a computer room air conditioner, CRAC, the method comprising:

   controlling the CRAC with a controller, the controller being configured to communicate with the CRAC;
   receiving an indication of a desired cooling capacity of the CRAC;
   providing a plurality of possible sets of operating parameters for the CRAC; determining a plurality of sets of estimated cooling outputs for the CRAC, each set of estimated cooling outputs corresponding to a respective one set of the plurality of possible sets of operating parameters; and
   selecting one set of operating parameters from the plurality of possible sets of operating parameters for the CRAC, the one set of operating parameters corresponding to a set of estimated cooling outputs of the plurality of sets of estimated cooling outputs that matches the desired cooling capacity,
   wherein determining the plurality of sets of estimated cooling outputs includes calculating the plurality of sets of estimated cooling outputs by performing at least one $\varepsilon$-NTU calculation for each set of estimated cooling outputs, performing at least one pressure calculation for each set of estimated cooling outputs, and performing at least one enthalpy calculation for each set of estimated cooling outputs.

2. The method of claim 1, further comprising controlling the CRAC with the controller to operate using the selected one set of operating parameters, wherein controlling the CRAC includes adjusting an evaporation temperature of a refrigerant in the CRAC, wherein adjusting the evaporation temperature may include adjusting a pressure of the refrigerant in the CRAC.

3. The method of claim 1, wherein the indication of the desired cooling capacity includes an indication of at least one measured condition, and/ or wherein each set of operating parameters of the plurality of possible sets of operating parameters includes a different respective refrigerant evaporating temperature.

4. The method of claim 3,
   wherein calculating the plurality of sets of estimated cooling outputs further includes:

   determining a respective set of estimated cooling outputs of the plurality of sets of estimated cooling outputs for each of the plurality of possible sets of operating parameters based at least in part on the at least one respective $\varepsilon$-NTU calculation, the at least one respective pressure calculation, and the at least one respective enthalpy calculation and/ or
   wherein the at least one $\varepsilon$-NTU calculation includes determining at least one efficiency of an evaporator of the CRAC using a respective set of operating parameters of the plurality of possible sets of operating parameters and/ or
   wherein the at least one pressure calculation includes determining at least one pressure of a refrigerant used by an evaporator of the CRAC using a respective set of operating parameters of the plurality of possible sets of operating parameters and/ or
   wherein the at least one enthalpy calculation includes determining at least one enthalpy value of a refrigerant used by an evaporator of the CRAC using a respective set of operating parameters of the plurality of possible sets of operating parameters and/ or
   wherein the at least one enthalpy calculation includes determining at least one enthalpy value based, at least in part, on the at least one pressure calculation and the at least one $\varepsilon$-NTU calculation and/or
   wherein calculating the plurality of sets of estimated cooling outputs further includes limiting at least part of at least one enthalpy value resulting from the at least one enthalpy calculation to within a bounding range.

5. The method of claim 1, wherein each set of the plurality of sets of estimated cooling outputs includes a respective estimated output cooling capacity, wherein the estimated set of cooling outputs may match the desired cooling capacity when the estimated set of cooling outputs includes the respective estimated output cooling capacity that has a similar value as the desired cooling capacity.

6. The method of claim 1, further comprising receiving a subsequent indication of at least one operating condition and adjusting a current set of operating parameters based at least in part on the at least one operating condition,
   wherein the at least one operating condition includes at least one of an air temperature, a refrigerant temperature, and a mass airflow, and/or
   wherein adjusting the current set of operating parameters includes calculating a second plurality of sets of second estimated cooling outputs based at least in part on the at least one operating condition.

7. A computer room air conditioner, CRAC, comprising:

   an evaporator (105) configured to cool air using a refrigerant;
   a refrigerant supply element configured to supply the refrigerant;
   at least one sensor (113, 309, 311, 313, 315) configured to measure at least one characteristic, and
   at least one controller (301)
   configured to:

   determine a plurality of sets of estimated cooling outputs based, at least in parton the at least one measured characteristic, each set of the plurality of sets of estimated cooling outputs corresponding to a respective one set of a plurality of possible sets of operating parameters,
   perform at least one $\varepsilon$-NTU calculation for each set of the plurality of estimated cooling outputs,
   perform at least one pressure calculation for each set of the plurality of estimated cooling outputs,
   perform at least one enthalpy calculation for each set of the plurality of estimated cooling outputs
   select one set of operating parameters from the plurality of possible sets of operating parameters, the one set of operating parameters corresponding to an estimated set of cooling outputs that matches a desired cooling capacity, and
   control the CRAC to operate using the selected one set of operating parameters.

8. The CRAC of claim 7, wherein controlling the CRAC includes adjusting at least one of a parameter of the refrigerant supply element, and a parameter of the evaporator, and/or
   wherein the at least one measured characteristic includes at least one of a
   refrigerant supply temperature, a mass airflow, and an air return temperature, and/or

wherein the controller is further configured to determine the desired cooling capacity based, at least in part, on the at least one measured characteristic and/or
wherein each set of operating parameters of the plurality of possible sets of operating parameters includes a different respective refrigerant evaporating temperature.

9. The, CRAC of claim 7, wherein the controller is configured to determine
a respective set of estimated cooling outputs of the plurality of sets of estimated cooling outputs based at least in part on the at least one respective $\varepsilon$-NTU calculation, the at - 4 -
least one respective pressure calculation, and the at least one respective enthalpy calculation and/ or
wherein the at least one $\varepsilon$-NTU calculation includes determining at least one efficiency of an evaporator of the CRAC operating using a respective set of operating parameters of the plurality of possible sets of operating parameters and/ or
wherein the at least one pressure calculation includes determining at least one refrigerant pressure of the refrigerant flow using a respective set of operating parameters of the plurality of possible sets of operating parameters and/ or
wherein the at least one enthalpy calculation includes determining at least one enthalpy value of the refrigerant flow using a respective set of operating parameters of the plurality of possible sets of operating parameters and/ or
wherein the controller is configured to perform the at least one enthalpy calculation based, at least in part, on the at least one pressure calculation and the at least one $\varepsilon$-NTU calculation, and/or
wherein the controller is configured to limit at least part of at least one enthalpy
value resulting from the at least one enthalpy calculation to within a bounding range.

10. The CRAC of claim 7, wherein each set of the plurality of sets of estimated cooling outputs includes a respective estimated output cooling capacity,
wherein the estimated set of cooling outputs may match the desired cooling capacity when the estimated set of cooling outputs includes the respective estimated output cooling capacity that has a similar value as the desired cooling capacity.

11. The CRAC of claim 10, wherein the controller is further configured to receive an indication of at least one subsequent operating condition, and to adjust a current set of operating parameters based, at least in part, on the at least one subsequent operating condition.

12. The CRAC of claim 11, wherein the controller is configured to calculate a second plurality of sets of second estimated cooling outputs based at least in part on the at least one subsequent operating condition.

13. The, CRAC of claim 7, wherein determining the plurality of sets of estimated cooling outputs includes calculating the plurality of sets of estimated cooling outputs.

14. A computer program which, when executed by a processor, is configured to perform a method according to any one of claims 1 to 6.

**Patentansprüche**

1. Ein Verfahren zum Steuern einer Computerraumklimaanlage, CRAC (Computer Room Air Conditioner), wobei das Verfahren Folgendes beinhaltet:

Steuern der CRAC mit einer Steuereinrichtung, wobei die Steuereinrichtung zum Kommunizieren mit der CRAC konfiguriert ist;
Empfangen einer Anzeige einer gewünschten Kühlkapazität der CRAC;
Bereitstellen einer Vielzahl von möglichen Sätzen von Betriebsparametern für die CRAC;
Bestimmen einer Vielzahl von Sätzen von geschätzten Kühlausgängen für die CRAC, wobei jeder Satz von geschätzten Kühlausgängen einem jeweiligen Satz der Vielzahl von möglichen Sätzen von Betriebsparametern entspricht; und
Auswählen eines Satzes von Betriebsparametern aus der Vielzahl von möglichen Sätzen von Betriebsparametern für die CRAC, wobei der eine Satz von Betriebsparametern einem Satz von geschätzten Kühlausgängen der Vielzahl von Sätzen von geschätzten Kühlausgängen entspricht, der mit der gewünschten Kühlkapazität übereinstimmt,
wobei das Bestimmen der Vielzahl von Sätzen von geschätzten Kühlausgängen das Berechnen der Vielzahl von Sätzen von geschätzten Kühlausgängen umfasst, indem mindestens eine $\varepsilon$-NTU-Berechnung für jeden Satz von geschätzten Kühlausgängen durchgeführt wird, mindestens eine Druckberechnung für jeden Satz von geschätzten Kühlausgängen durchgeführt wird und mindestens eine Enthalpieberechnung für jeden Satz von geschätzten Kühlausgängen durchgeführt wird.

2. Verfahren gemäß Anspruch 1, ferner beinhaltend das Steuern der CRAC mit der Steuereinrichtung für den Betrieb unter Verwendung des ausgewählten Satzes von Betriebsparametern, wobei das Steuern der CRAC das Einstellen einer Verdampfungstemperatur eines Kühlmittels in der CRAC umfasst, wobei das Einstellen der Verdampfungstemperatur das Einstellen eines Drucks des Kühlmittels in der CRAC umfassen kann.

3. Verfahren gemäß Anspruch 1, wobei die Anzeige der gewünschten Kühlkapazität eine Anzeige mindestens eines gemessenen Zustands umfasst und/oder wobei jeder Satz von Betriebsparametern der Vielzahl von möglichen Sätzen von Betriebsparametern eine unterschiedliche jeweilige Kühlmittelverdampfungstemperatur umfasst.

4. Verfahren gemäß Anspruch 3,
wobei das Berechnen der Vielzahl von Sätzen von geschätzten Kühllausgängen ferner Folgendes umfasst:

Bestimmen eines jeweiligen Satzes von geschätzten Kühlausgängen der Vielzahl von Sätzen von geschätzten Kühlausgängen für jeden der Vielzahl von möglichen Sätzen von Betriebsparametern, basierend mindestens teilweise auf der mindestens einen jeweiligen $\varepsilon$-NTU-Berechnung, der mindestens einen jeweiligen Druckberechnung und der mindestens einen jeweiligen Enthalpieberechnung, und/oder wobei die mindestens eine $\varepsilon$-NTU-Berechnung das Bestimmen mindestens eines Wirkungsgrades eines Verdampfers der CRAC unter Verwendung eines jeweiligen Satzes von Betriebsparametern der Vielzahl von möglichen Sätzen von Betriebsparametern umfasst und/oder
wobei die mindestens eine Druckberechnung das Bestimmen mindestens eines Drucks eines von einem Verdampfer der CRAC verwendeten Kühlmittels unter Verwendung eines jeweiligen Satzes von Betriebsparametern der Vielzahl von möglichen Sätzen von Betriebsparametern umfasst, und/oder
wobei die mindestens eine Enthalpieberechnung das Bestimmen mindestens eines Enthalpiewertes eines von einem Verdampfer der CRAC verwendeten Kühlmittels unter Verwendung eines jeweiligen Satzes von Betriebsparametern der Vielzahl von möglichen Sätzen von Betriebsparametern umfasst, und/oder wobei die mindestens eine Enthalpieberechnung das Bestimmen mindestens eines Enthalpiewertes, basierend mindestens teilweise auf der mindestens einen Druckberechnung und der mindestens einen $\varepsilon$-NTU-Berechnung, umfasst, und/oder wobei das Berechnen der Vielzahl von Sätzen von geschätzten Kühlausgängen ferner das Begrenzen mindestens eines Teils mindestens eines Enthalpiewertes, der sich aus der mindestens einen Enthalpieberechnung ergibt, auf einen Grenzbereich umfasst.

5. Verfahren gemäß Anspruch 1, wobei jeder Satz der Vielzahl von Sätzen von geschätzten Kühlausgängen eine jeweilige geschätzte Ausgangskühlkapazität umfasst, wobei der geschätzte Satz von Kühlausgängen mit der gewünschten Kühlkapazität übereinstimmen kann, wenn der geschätzte Satz von Kühlausgängen die jeweilige geschätzte Ausgangskühlkapazität umfasst, die einen ähnlichen Wert wie die gewünschte Kühlkapazität aufweist.

6. Verfahren gemäß Anspruch 1, ferner beinhaltend das Empfangen einer nachfolgenden Anzeige mindestens eines Betriebszustands und das Einstellen eines aktuellen Satzes von Betriebsparametern, basierend mindestens teilweise auf dem mindestens einen Betriebszustand,
wobei der mindestens eine Betriebszustand mindestens eines von einer Lufttemperatur, einer Kühlmitteltemperatur und einem Luftmassenstrom umfasst, und/oder wobei das Einstellen des aktuellen Satzes von Betriebsparametern das Berechnen einer zweiten Vielzahl von Sätzen von zweiten geschätzten Kühlausgängen, basierend mindestens teilweise auf dem mindestens einen Betriebszustand, umfasst.

7. Eine Computerraumklimaanlage, CRAC, die Folgendes beinhaltet:

einen Verdampfer (105), der zum Kühlen von Luft unter Verwendung eines Kühlmittels konfiguriert ist;
ein Kühlmittelzufuhrelement, das zum Zuführen des Kühlmittels konfiguriert ist;
mindestens einen Sensor (113, 309, 311, 313, 315), der zum Messen mindestens einer Charakteristik konfiguriert ist, und
mindestens eine Steuereinrichtung (301),
die für Folgendes konfiguriert ist:

Bestimmen einer Vielzahl von Sätzen von geschätzten Kühlausgängen, basierend mindestens teilweise auf der mindestens einen gemessenen Charakteristik, wobei jeder Satz der Vielzahl von Sätzen von geschätzten Kühlausgängen einem jeweiligen Satz einer Vielzahl von möglichen Sätzen von Betriebsparametern entspricht,

Durchführen mindestens einer $\varepsilon$-NTU-Berechnung für jeden Satz der Vielzahl von geschätzten Kühlausgängen,

Durchführen mindestens einer Druckberechnung für jeden Satz der Vielzahl von geschätzten Kühlausgängen,

Durchführen mindestens einer Enthalpieberechnung für jeden Satz der Vielzahl von geschätzten Kühlausgängen,

Auswählen eines Satzes von Betriebsparametern aus der Vielzahl von möglichen Sätzen von Betriebsparametern, wobei der eine Satz von Betriebsparametern einem geschätzten Satz von Kühlausgängen entspricht, der mit der gewünschten Kühlkapazität übereinstimmt, und

Steuern der CRAC für den Betrieb unter Verwendung des ausgewählten Satzes von Betriebsparametern.

8. CRAC gemäß Anspruch 7, wobei das Steuern der CRAC das Einstellen mindestens eines von einem Parameter des Kühlmittelzufuhrelements und einem Parameter des Verdampfers umfasst, und/oder

wobei die mindestens eine gemessene Charakteristik mindestens eines von einer Kühlmittelzufuhrtemperatur, einem Luftmassenstrom und einer Luftrücklauftemperatur umfasst, und/oder

wobei die Steuereinrichtung ferner zum Bestimmen der gewünschten Kühlkapazität, basierend mindestens teilweise auf der mindestens einen gemessenen Charakteristik, konfiguriert ist, und/oder

wobei jeder Satz von Betriebsparametern der Vielzahl von möglichen Sätzen von Betriebsparametern eine unterschiedliche jeweilige Kühlmittelverdampfungstemperatur umfasst.

9. CRAC gemäß Anspruch 7, wobei die Steuereinrichtung zum Bestimmen eines jeweiligen Satzes von geschätzten Kühlausgängen der Vielzahl von Sätzen von geschätzten Kühlausgängen, basierend mindestens teilweise auf der mindestens einen jeweiligen $\varepsilon$-NTU-Berechnung, der mindestens einen jeweiligen Druckberechnung und der mindestens einen jeweiligen Enthalpieberechnung, konfiguriert ist, und/oder wobei die mindestens eine $\varepsilon$-NTU-Berechnung das Bestimmen mindestens eines Wirkungsgrades eines Verdampfers der in Betrieb befindlichen CRAC unter Verwendung eines jeweiligen Satzes von Betriebsparametern der Vielzahl von möglichen Sätzen von Betriebsparametern umfasst, und/oder wobei die mindestens eine Druckberechnung das Bestimmen mindestens eines Kühlmitteldrucks des Kühlmittelstroms unter Verwendung eines jeweiligen Satzes von Betriebsparametern der Vielzahl von möglichen Sätzen von Betriebsparametern umfasst, und/oder

wobei die mindestens eine Enthalpieberechnung das Bestimmen mindestens eines Enthalpiewertes des Kühlmittelstroms unter Verwendung eines jeweiligen Satzes von Betriebsparametern der Vielzahl von möglichen Sätzen von Betriebsparametern umfasst, und/oder

wobei die Steuereinrichtung zum Durchführen der mindestens einen Enthalpieberechnung, basierend mindestens teilweise auf der mindestens einen Druckberechnung und der mindestens einen $\varepsilon$-NTU-Berechnung, konfiguriert ist, und/oder

wobei die Steuereinrichtung zum Begrenzen mindestens eines Teils mindestens eines Enthalpiewertes, der sich aus der mindestens einen Enthalpieberechnung ergibt, auf einen Grenzbereich konfiguriert ist.

10. CRAC gemäß Anspruch 7, wobei jeder Satz der Vielzahl von Sätzen von geschätzten Kühlausgängen eine jeweilige geschätzte Ausgangskühlkapazität umfasst,

wobei der geschätzte Satz von Kühlausgängen mit der gewünschten Kühlkapazität übereinstimmen kann, wenn der geschätzte Satz von Kühlausgängen die jeweilige geschätzte Ausgangskühlkapazität umfasst, die einen ähnlichen Wert wie die gewünschte Kühlkapazität aufweist.

11. CRAC gemäß Anspruch 10, wobei die Steuereinrichtung ferner zum Empfangen einer Anzeige mindestens eines nachfolgenden Betriebszustands und zum Einstellen eines aktuellen Satzes von Betriebsparametern, basierend mindestens teilweise auf dem mindestens einen nachfolgenden Betriebszustand, konfiguriert ist.

12. CRAC gemäß Anspruch 11, wobei die Steuereinrichtung zum Berechnen einer zweiten Vielzahl von Sätzen von zweiten geschätzten Kühlausgängen, basierend mindestens teilweise auf dem mindestens einen nachfolgenden Betriebszustand, konfiguriert ist.

13. CRAC gemäß Anspruch 7, wobei das Bestimmen der Vielzahl von Sätzen von geschätzten Kühlausgängen das Berechnen der Vielzahl von Sätzen von geschätzten Kühlausgängen umfasst.

**14.** Ein Computerprogramm, das, wenn es von einem Prozessor ausgeführt wird, zum Durchführen eines Verfahrens gemäß einem der Ansprüche 1 bis 6 konfiguriert ist.

**Revendications**

**1.** Un procédé de commande d'un système de conditionnement d'air de salle informatique, CRAC (Computer Room Air Conditioner), le procédé comprenant :

le fait de commander le CRAC avec un système de commande, le système de commande étant configuré afin de communiquer avec le CRAC ;
le fait de recevoir une indication d'une capacité de refroidissement souhaitée du CRAC;
le fait de fournir une pluralité d'ensembles possibles de paramètres de fonctionnement pour le CRAC ;
le fait de déterminer une pluralité d'ensembles de puissances de refroidissement estimées pour le CRAC, chaque ensemble de puissances de refroidissement estimées correspondant à un ensemble respectif de la pluralité d'ensembles possibles de paramètres de fonctionnement ; et
le fait de sélectionner un ensemble de paramètres de fonctionnement parmi la pluralité d'ensembles possibles de paramètres de fonctionnement pour le CRAC, cet un ensemble de paramètres de fonctionnement correspondant à un ensemble de puissances de refroidissement estimées de la pluralité d'ensembles de puissances de refroidissement estimées qui concorde avec la capacité de refroidissement souhaitée, dans lequel le fait de déterminer la pluralité d'ensembles de puissances de refroidissement estimées inclut le fait de calculer la pluralité d'ensembles de puissances de refroidissement estimées en réalisant au moins un calcul $\varepsilon$-NTU pour chaque ensemble de puissances de refroidissement estimées, en réalisant au moins un calcul de pression pour chaque ensemble de puissances de refroidissement estimées, et en réalisant au moins un calcul d'enthalpie pour chaque ensemble de puissances de refroidissement estimées.

**2.** Le procédé de la revendication 1, comprenant en sus le fait de commander le CRAC avec le système de commande afin qu'il fonctionne en utilisant cet un ensemble sélectionné de paramètres de fonctionnement, dans lequel le fait de commander le CRAC inclut le fait d'ajuster une température d'évaporation d'un réfrigérant dans le CRAC, dans lequel le fait d'ajuster la température d'évaporation peut inclure le fait d'ajuster une pression du réfrigérant dans le CRAC.

**3.** Le procédé de la revendication 1, dans lequel l'indication de la capacité de refroidissement souhaitée inclut une indication d'au moins une condition mesurée, et/ou dans lequel chaque ensemble de paramètres de fonctionnement de la pluralité d'ensembles possibles de paramètres de fonctionnement inclut une température d'évaporation de réfrigérant respective différente.

**4.** Le procédé de la revendication 3,
dans lequel le fait de calculer la pluralité d'ensembles de puissances de refroidissement estimées inclut en sus :

le fait de déterminer un ensemble respectif de puissances de refroidissement estimées de la pluralité d'ensembles de puissances de refroidissement estimées pour chaque ensemble de la pluralité d'ensembles possibles de paramètres de fonctionnement sur la base au moins en partie de l'au moins un calcul $\varepsilon$-NTU respectif, de l'au moins un calcul de pression respectif, et de l'au moins un calcul d'enthalpie respectif et/ou dans lequel l'au moins un calcul $\varepsilon$-NTU inclut le fait de déterminer au moins une efficacité d'un évaporateur du CRAC en utilisant un ensemble respectif de paramètres de fonctionnement de la pluralité d'ensembles possibles de paramètres de fonctionnement et/ou
dans lequel l'au moins un calcul de pression inclut le fait de déterminer au moins une pression d'un réfrigérant utilisé par un évaporateur du CRAC en utilisant un ensemble respectif de paramètres de fonctionnement de la pluralité d'ensembles possibles de paramètres de fonctionnement et/ou
dans lequel l'au moins un calcul d'enthalpie inclut le fait de déterminer au moins une valeur d'enthalpie d'un réfrigérant utilisé par un évaporateur du CRAC en utilisant un ensemble respectif de paramètres de fonctionnement de la pluralité d'ensembles possibles de paramètres de fonctionnement et/ou
dans lequel l'au moins un calcul d'enthalpie inclut le fait de déterminer au moins une valeur d'enthalpie sur la base, au moins en partie, de l'au moins un calcul de pression et de l'au moins un calcul $\varepsilon$-NTU et/ou
dans lequel le fait de calculer la pluralité d'ensembles de puissances de refroidissement estimées inclut en sus le fait de limiter au moins une partie d'au moins une valeur d'enthalpie résultant de l'au moins un calcul d'enthalpie pour qu'elle reste au sein d'un intervalle limite.

**5.** Le procédé de la revendication 1, dans lequel chaque ensemble de la pluralité d'ensembles de puissances de refroidissement estimées inclut une capacité de refroidissement en puissance estimée respective, dans lequel l'ensemble estimé de puissances de refroidissement peut concorder avec la capacité de refroidissement souhaitée lorsque l'ensemble estimé de puissances de refroidissement inclut la capacité de refroidissement en puissance estimée respective qui a une valeur similaire à la capacité de refroidissement souhaitée.

**6.** Le procédé de la revendication 1, comprenant en sus le fait de recevoir une indication subséquente d'au moins une condition de fonctionnement et le fait d'ajuster un ensemble actuel de paramètres de fonctionnement sur la base au moins en partie de l'au moins une condition de fonctionnement,
dans lequel l'au moins une condition de fonctionnement inclut au moins une condition parmi une température d'air, une température de réfrigérant, et un débit d'air massique,
et/ou
dans lequel le fait d'ajuster l'ensemble actuel de paramètres de fonctionnement inclut le fait de calculer une deuxième pluralité d'ensembles de deuxièmes puissances de refroidissement estimées sur la base au moins en partie de l'au moins une condition de fonctionnement.

**7.** Un système de conditionnement d'air de salle informatique, CRAC, comprenant :

un évaporateur (105) configuré afin de refroidir de l'air en utilisant un réfrigérant ;
un élément d'apport de réfrigérant configuré afin d'apporter le réfrigérant ;
au moins un capteur (113, 309, 311, 313, 315) configuré afin de mesurer au moins une caractéristique, et
au moins un système de commande (301)
configuré afin :

de déterminer une pluralité d'ensembles de puissances de refroidissement estimées sur la base, au moins en partie, de l'au moins une caractéristique mesurée, chaque ensemble de la pluralité d'ensembles de puissances de refroidissement estimées correspondant à un ensemble respectif d'une pluralité d'ensembles possibles de paramètres de fonctionnement,
de réaliser au moins un calcul $\varepsilon$-NTU pour chaque ensemble de la pluralité de puissances de refroidissement estimées,
de réaliser au moins un calcul de pression pour chaque ensemble de la pluralité de puissances de refroidissement estimées,
de réaliser au moins un calcul d'enthalpie pour chaque ensemble de la pluralité de puissances de refroidissement estimées,
de sélectionner un ensemble de paramètres de fonctionnement parmi la pluralité d'ensembles possibles de paramètres de fonctionnement, cet un ensemble de paramètres de fonctionnement correspondant à un ensemble estimé de puissances de refroidissement qui concorde avec une capacité de refroidissement souhaitée, et
de commander le CRAC afin qu'il fonctionne en utilisant cet un ensemble sélectionné de paramètres de fonctionnement.

**8.** Le CRAC de la revendication 7, dans lequel le fait de commander le CRAC inclut le fait d'ajuster au moins un paramètre parmi un paramètre de l'élément d'apport de réfrigérant, et un paramètre de l'évaporateur, et/ou
dans lequel l'au moins une caractéristique mesurée inclut au moins une caractéristique parmi une température d'apport de réfrigérant, un débit d'air massique, et une température de retour d'air, et/ou
dans lequel le système de commande est en sus configuré afin de déterminer la capacité de refroidissement souhaitée sur la base, au moins en partie, de l'au moins une caractéristique mesurée et/ou
dans lequel chaque ensemble de paramètres de fonctionnement de la pluralité d'ensembles possibles de paramètres de fonctionnement inclut une température d'évaporation de réfrigérant respective différente.

**9.** Le CRAC de la revendication 7, dans lequel le système de commande est configuré afin de déterminer un ensemble respectif de puissances de refroidissement estimées de la pluralité d'ensembles de puissances de refroidissement estimées sur la base au moins en partie de l'au moins un calcul $\varepsilon$-NTU respectif, de l'au moins un calcul de pression respectif, et de l'au moins un calcul d'enthalpie respectif et/ou
dans lequel l'au moins un calcul $\varepsilon$-NTU inclut le fait de déterminer au moins une efficacité d'un évaporateur du CRAC fonctionnant en utilisant un ensemble respectif de paramètres de fonctionnement de la pluralité d'ensembles possibles de paramètres de fonctionnement et/ou
dans lequel l'au moins un calcul de pression inclut le fait de déterminer au moins une pression de réfrigérant du flux de réfrigérant en utilisant un ensemble respectif de paramètres de fonctionnement de la pluralité d'ensembles possibles de paramètres de fonctionnement et/ou

dans lequel l'au moins un calcul d'enthalpie inclut le fait de déterminer au moins une valeur d'enthalpie du flux de réfrigérant en utilisant un ensemble respectif de paramètres de fonctionnement de la pluralité d'ensembles possibles de paramètres de fonctionnement et/ou

dans lequel le système de commande est configuré afin de réaliser l'au moins un calcul d'enthalpie sur la base, au moins en partie, de l'au moins un calcul de pression et de l'au moins un calcul $\varepsilon$-NTU, et/ou

dans lequel le système de commande est configuré afin de limiter au moins une partie d'au moins une valeur d'enthalpie résultant de l'au moins un calcul d'enthalpie pour qu'elle reste au sein d'un intervalle limite.

10. Le CRAC de la revendication 7, dans lequel chaque ensemble de la pluralité d'ensembles de puissances de refroidissement estimées inclut une capacité de refroidissement en puissance estimée respective,
dans lequel l'ensemble estimé de puissances de refroidissement peut concorder avec la capacité de refroidissement souhaitée lorsque l'ensemble estimé de puissances de refroidissement inclut la capacité de refroidissement en puissance estimée respective qui a une valeur similaire à la capacité de refroidissement souhaitée.

11. Le CRAC de la revendication 10, dans lequel le système de commande est en sus configuré afin de recevoir une indication d'au moins une condition de fonctionnement subséquente, et afin d'ajuster un ensemble actuel de paramètres de fonctionnement sur la base, au moins en partie, de l'au moins une condition de fonctionnement subséquente.

12. Le CRAC de la revendication 11, dans lequel le système de commande est configuré afin de calculer une deuxième pluralité d'ensembles de deuxièmes puissances de refroidissement estimées sur la base au moins en partie de l'au moins une condition de fonctionnement subséquente.

13. Le CRAC de la revendication 7, dans lequel le fait de déterminer la pluralité d'ensembles de puissances de refroidissement estimées inclut le fait de calculer la pluralité d'ensembles de puissances de refroidissement estimées.

14. Un programme informatique qui, lorsqu'il est exécuté par un processeur, est configuré afin de réaliser un procédé selon n'importe laquelle des revendications 1 à 6.

FIGURE 1

FIGURE 2

FIGURE 3

400

401

BEGIN

403

RECEIVE AN INDICATION OF A DESIRED
COOLING CAPACITY

405

RECEIVE AT LEAST ONE INDICATION OF
AT LEAST ONE MEASURED CONDITION

407

CALCULATE COOLING OUTPUTS AT A PLURALITY
OF POSSIBLE OPERATING PARAMETERS

409

SELECT AN OPERATING PARAMETER THAT
IS CALCULATED TO PROVIDE A COOLING OUTPUT
THAT MATCHES THE DESIRED COOLING CAPACITY

411

CONTROL A COOLING DEVICE TO OPERATE
AT THE SELECTED OPERATING PARAMETER

413

END

FIGURE 4

500

501

BEGIN

503

BASED ON INPUT OPERATING CONDITIONS AND KNOWN CHRACTERISTICS, PERFORM AT LEAST ONE E-NTU CALCULATION

505

BASED ON INPUT OPERATING CONDITION AND KNOWN CHRACTERISTICS, PERFORM AT LEAST ONE PRESSURE CALCULATION

507

BASED ON THE PRESSURE CALCULATION AND E-NTU CALCULATION, DETERMINE AT LEAST ONE ENTHALPY VALUE FOR REFRIGERANT OF A COOLING DEVICE

509

ADJUST THE DETERMINED ENTHAPLY VALUE TO BE WITHIN A BOUNDARY RANGE

511

CALCULATE COOLING OUTPUTS BASED, AT LEAST IN PART, ON THE ADJUSTED ENTHAPLY VALUE, PRESSURE CALCULATION AND E-NTU CALCULATION

513

END

FIGURE 5

FIGURE 6

**EP 2 171 375 B1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP H07269926 B
- WO 2006034718 A
- US 33587406
- US 11335856 B
- US 11335901 B
- US 11504382 B
- US 11504370 B